Europäisches Patentamt

European Patent Office

Office européen des brevets

(11) Publication number: **0 189 252**
**A2**

# EUROPEAN PATENT APPLICATION

(21) Application number: 86300116.0

(51) Int. Cl.⁴: **H 01 S 3/103**

(22) Date of filing: 09.01.86

(30) Priority: 14.01.85 JP 4242/85

(43) Date of publication of application: 30.07.86
Bulletin 86/31

(84) Designated Contracting States: **DE FR GB**

(71) Applicant: **NEC CORPORATION, 33-1, Shiba 5-chome, Minato-ku, Tokyo 108 (JP)**

(72) Inventor: **Emura, Katsumi, c/o NEC Corporation 33-1, Shiba 5-chome, Minato-ku Tokyo (JP)**
Inventor: **Minemura, Kouichi, c/o NEC Corporation 33-1, Shiba 5-chome, Minato-ku Tokyo (JP)**
Inventor: **Yamaguchi, Masayuki, c/o NEC Corporation 33-1, Shiba 5-chome, Minato-ku Tokyo (JP)**

(74) Representative: **Orchard, Oliver John, JOHN ORCHARD & CO. Staple Inn Buildings North High Holborn, London WC1V 7PZ (GB)**

(54) Semiconductor laser direct frequency modulation system.

(57) A semiconductor laser modulation system includes a semiconductor laser element having first and second regions, whose laser oscillation frequency is adjusted by currents injected into the first and second regions, means for supplying a biasing current of or above the threshold to the first region, and means for supplying a biasing current and a modulation signal current to the second region, wherein the semiconductor laser element generates a frequency modulated laser beam by varying the refractive index of the second region with the modulation signal current.

# SEMICONDUCTOR LASER DIRECT FREQUENCY MODULATION SYSTEM

## BACKGROUND OF THE INVENTION

The present invention relates to frequency modulation of laser beams, and more particularly to direct frequency modulation of semiconductor lasers.

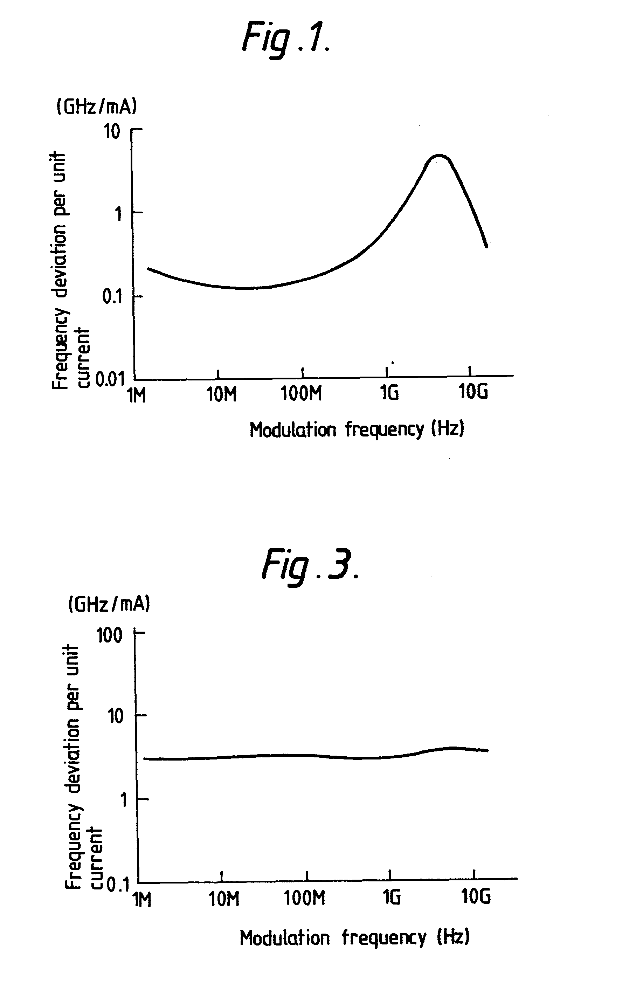

Performance characteristics of semiconductor laser have much improved in recent years, and there are now available semiconductor lasers capable of oscillating in a single longitudinal mode and having a high degree of spectral purity, making possible realization of a coherent optical transmission using information on the frequency and phase of light beams. In an FSK heterodyne optical communication system using frequency information, it is attempted to achieve direct FSK modulation of the output light beams of a semiconductor laser by biasing the semiconductor laser beyond its threshold and minutely varying the current injected into it around the biasing point with pulse signals. (See, for instance, S. Saito, Y. Yamamoto and T. Kimura, "S/N and error rate evaluation for an optical FSK-heterodyne detection system using semiconductor lasers", IEEE Journal of Quantum Electronics, vol. QE-19, No. 2, February 1983.) This direct frequency modulation of semiconductor laser beams is caused to take place by two effects: variations in the injection current alter the carrier density in and, accordingly the refractive index of, the laser medium on the one hand and, on the other, the temperature of the laser medium changes in response to the variations of the injection current, thereby inviting variations in the refractive index of the laser medium. Since the variations of carrier density are affected by the relaxation oscillation of the semiconductor laser, the carrier variation may differ with the modulation frequency. It is observed that, in a frequency range from 10 MHz to several GHz, the higher the modulation frequency, the greater the frequency deviation per unit of injection current. In a low frequency range, the temperature of the semiconductor laser is varied by the injection current, the frequency deviation per unit of injection current increasing with a decrease in frequency. FIG. 1 shows a typical frequency deviation characteristic observed with a conventional semiconductor laser. Consequently, the efficiency of frequency modulation depends on the modulation frequency, and the modulated waveform is distorted. In pulse transmission subject to this distortion, receiver sensitivity deteriorates.

SUMMARY OF THE INVENTION

An object of the present invention, therefore, is to provide a direct frequency modulation system for producing modulated laser beams less susceptible to waveform distortion.

- 3 -

In an embodiment of the invention to be described, there is a semiconductor laser modulation system comprising: a semiconductor laser element further consisting of first and second regions, whose laser oscillation frequency is adjusted by currents injected into said first and second regions; means for supplying a biasing current of or above the threshold to said first region; and means for supplying a biasingg current and a modulation signal current to said second region, wherein said semiconductor laser element generates a frequency modulated laser beam by varying the refractive index of said second region with said modulation signal current.

According to a specific feature of the embodiment, each of said first and second regions includes an active layer capable of emitting light upon injection of the current and an optical guide layer adjoining said active layer.

According to another specific feature, the biasing current supplied to said second region is set at or below the threshold of said second region.

The inventors have found that, if the first region or laser region is biased at a constant current of or above the threshold, the second region or modulation region is biased at a constant current of or below the threshold, and the injection currents is varied minutely with a modulation signal, the frequency modulation efficiency is not dependent on the modulation frequency. That the bias current for the second region or modulation region is at or below the threshold means a state in which the gain per unit length of the modulation region is smaller than the equivalent loss per unit length. In the absence of an active layer in the second region, the bias current for the second region is not particularlly limited. The modulation region, since it is biased at or below the threshold, does not act as an active region. Therefore, if the carrier density is varied with the modulation signal current, only the refractive index will vary with that, but the modulation region is free from the relaxation oscillation, resulting in a uniform frequency modulation characteristic. Further, the carrier density in the laser region is clamped in a state of laser oscillation threshold, and accordingly causes little carrier density change by current injection. In the modulation region, in contrast, the injection current almost wholly contributes to carrier density variation, so that efficient frequency modulation can be achieved. The frequency deviation due to carrier density variation is far greater than the uneven frequency deviation caused by temperature variation, and therefore the influence of temperature variation hardly reveals itself.

Where the laser region is a distributed feedback type semiconductor laser, one of the factors determining its oscillation frequency is the relative phase condition between the end facet of the resonator and the diffraction grating of the semiconductor laser. Upon injection of a current into the modulation region of the integrated type semiconductor laser element for use hereunder, the carrier density of the modulation region varies, and so does the refractive index. This has a consequence that, equivalently, the phase condition of the modulation region end facet as viewed from the distributed feedback region side is altered, resulting in a change in oscillation frequency.

Next is considered a case in which the laser region consists of a distributed Bragg reflector (DBR) type laser. Where a modulation region is composed in cascade connection to the active region of a DBR type laser, injection of a modulation current to the modulation region alters the refractive index of the modulation region and the equivalent resonator length of the integrated semiconductor laser element as a whole, and there is provided an output light beam which is frequency modulated by the modulation current. In this instance, too, frequency modulation can be realized with a highly efficient and uniform frequency characteristic.

BRIEF DESCRIPTION OF THE DRAWINGS

Further features and advantages of this invention will become apparent from the following detailed description taken together with the drawing in which:

FIG. 1 shows a typical frequency deviation vs. modulation frequency characteristic achieved when an ordinary semiconductor laser is directly frequency modulated.

FIG. 2 is a block diagram of a direct frequency modulation system, which is a preferred embodiment of the present invention; and

FIG. 3 is a diagram showing a frequency modulation characteristic achieved by the system of FIG. 2.

DETAILED DESCRIPTION OF THE PREFERRED EMBODIMENT

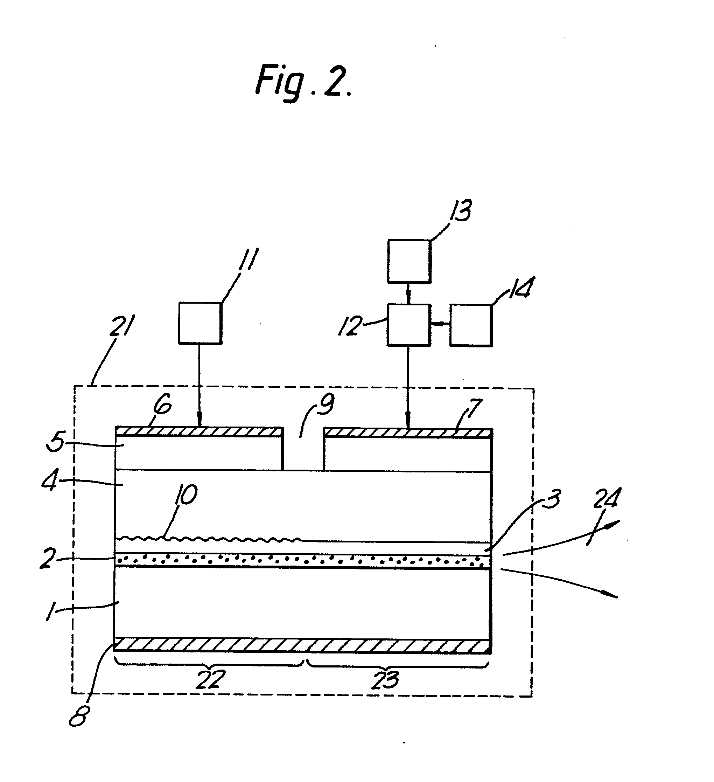

Referring to FIG. 2, the laser modulation system, which is a preferred embodiment of the present invention, includes an integrated semiconductor laser element 21, a driving circuit 11, a modulation circuit 12, a signal generator 13 and a biasing circuit 14.

The semiconductor laser element 21 can be further divided into a laser region 22 and a modulation region 23. The oscillation frequency of the laser is determined by the facet condition of the laser region 22 and modulation region 23, and currents injected into these regions. The laser element 21 includes an active layer 2, which emits light upon an injection current, and a guide layer 3 for guiding light beams, which adjoins the active layer 2. On the surface of the guide layer 3 opposite to the active layer 2 is formed a diffraction grating 10 of a prescribed pitch up to around its center. The diffraction grating 10 primarily determines the oscillation frequency in the laser region 22.

The integrated semiconductor laser element 21 was prepared in the following manner. First the InGaAsP active layer 2 of 1.3 microns in wavelength composition and the n-InGaAsP optical guide layer 3 of 1.2 microns in wavelength composition were epitaxially grown over an n-InP substrate 1, and the diffraction grating 10 of about 2000 $\overset{\circ}{A}$ in pitch was formed only on that part of the upper face of the optical guide layer 3 which would constitute the laser region 22. The other part of the optical guide layer 3 which would constitute the modulation region 23 was made flat. After that, a P-InP clad layer 4 and a $P^+$-InGaAsP cap layer 5 were epitaxially grown all over the optical guide layer 3. Then, a driving electrode 6 and a modulating electrode 7 were formed over the cap layer 5 above the laser region 22 and the modulation region 23, respectively, and underneath the n-InP substrate 1 was formed an n-electrode 8. Between the driving electrode 6 and the modulating electrode 7 was formed a groove 9 deeper than the cap layer 5 to improve electric isolation between the two electrodes. As such a laser element, reference may be made to a technical article of "Lasing mode and spectral linewidth control by phase tunable DFB-DC-PBH LD", by M. Kitamura et al., Ninth IEEE international laser conference, Rio de Janeiro, Aug. 1984.

The laser region 22 of this integrated semiconductor laser element 21 is biased at or above the threshold by an injection current from the driving circuit 11 to achieve laser oscillation. On the other hand, the modulation region 23 is driven in the following manner. To the modulation circuit 12 are supplied a minute modulation signal from the signal generator 13 and a DC from the biasing circuit 14. The modulation circuit 12 serves to put together these two currents. Thus a current resulting from the addition of the modulating current to the biasing current is used to drive the modulation region 23. As the modulation region 23 itself is so set as not to exceed the threshold, variations in the injected current are directly reflected on the variations of the carrier density of the modulation region 23, and it is thereby made possible to achieve highly efficient frequency modulation whose frequency deviation is not dependent on the modulation frequency.

The threshold currents of the laser region 22 and the modulation region 23 of the integrated semiconductor laser element 21 in this preferred embodiment of the invention are both 30 mA. The current injected into the laser region 22 here is set at 100 mA. The biasing current to the modulation region 23 is set at 15 mA, and the amplitude of the modulation current is 2 mA on a peak-to-peak basis. Changing the frequency of the sine wave from the signal generator 13 under these conditions, the modulation characteristic was measured. The obtained result, as shown in FIG. 3, indicates the frequency deviation per unit of current, i.e. the modulation efficiency, to be as high as 3 GHz/mA and a modulation characteristic whose frequency deviation is not dependent on the modulation frequency.

Then NRZ random signals of 100 Mb/s was generated from the signal generator 13 to achieve modulation with pulse signals and fed to the modulation region 23 via the modulation circuit 12 to accomplish two-level frequency modulation. The bias level was set at the same condition as the aforementioned instance, and the modulation pulse current was set at 0.5 mA in terms of the peak-to-peak current. The signal waveform was observed with the direct optical frequency discrimination detection by passing a modulated output light beam 24 from the integrated semiconductor laser element 21 through a Fabry-Perot etalon. The waveform thereby obtained was found to have reproduced the modulated waveform with substantial fidelity, and no waveform distortion attributable to frequency modulation was witnessed in the modulation region 23.

Many variations of the present invention are conceivable besides the preferred embodiment described above. For instance, although this embodiment uses an integrated semiconductor laser element 21 in whose laser region 22 the diffraction grating for distributed feedback is over the active layer 2, there may as well be used an integrated semiconductor laser element wherein the diffraction grating 10 is under the active layer 2. Or under the present invention, there can also be used an integrated semiconductor laser element in whose laser region 22 the diffraction grating 10 is only partially formed and the region in which the diffraction grating 10 is present is made a non-injection region, i.e. whose laser region 22 consists of a DBR type laser. Further, frequency modulation may be accomplished with the wiring so changed as to make the region 23 of the laser element in FIG. 2 a laser region and the region 22 of same a modulation region. The striped structure of the integrated semiconductor laser element 1 is not limited to the buried hetero structure of this preferred embodiment, but may be any one of various other structure, including a planar striped structure and a transverse junction striped structure. The oscillation wavelength of the integrated semiconductor laser element 1 is not confined to 1.3 microns, but may be one of many other wavelengths including 1.5 microns. There may as well be used an integrated semiconductor laser element 21 whose end facet on the modulation region side 23 is so coated as to reduce its reflecting power. In this case, the optical power of the modulated output light beam 24 can be increased.

As hitherto described, by the direct frequency modulation system for laser light beams hereunder, the modulation characteristic in direct frequency modulation is free from modulation frequency-dependence. Therefore, waveform distortion due to direct modulation can be thereby eliminated. For instance, in the direct modulation of a semiconductor laser with 100 Mb/s NRZ signals by Saito et al., distortions were observed in pulse waveforms on account of the uneven frequency modulation characteristic of the semiconductor laser, and the deterioration of receiver sensitivity attributable to the waveform distortion reached 10 dB or even more at its worst. In contrast, if an integrated semiconductor laser element is used for frequency modulation as in the present invention, the frequency modulation characteristic will be uniform vis-a-vis the modulation frequency, so that there are hardly observed waveform distortions due to direct modulation.

CLAIMS

1.    A semiconductor laser modulation system comprising:

a semiconductor laser element further including first and second regions, whose laser oscillation frequency is adjusted by currents injected into said first and second regions;

means for supplying a biasing current of or above the threshold to said first region; and

means for supplying a biasing current and a modulation signal current to said second region,

wherein said semiconductor laser element generates a frequency modulated laser beam by varying the refractive index of said second region with said modulation signal current.

2.    A semiconductor laser modulation system, as claimed in Claim 1, wherein each of said first and second regions includes an active layer capable of emitting light upon injection of the current and an optical guide layer adjoining said active layer.

3.    A semiconductor laser modulation system, as claimed in Claim 2, wherein the biasing current supplied to said second region is set at or below the threshold of said second region.

1/2

## Fig.1.

## Fig.3.

# Fig. 2.